# EUROPEAN PATENT APPLICATION

(11) **EP 3 832 814 A1**
(43) Date of publication of application: **09.06.2021**
(21) Application number: 18927741.1
(22) Date of filing: 25.12.2018
(51) Int. Cl.: H01S 3/067, H01S 3/094

(54) **OPPOSING PUMP STRUCTURE FOR TWIN 980-NM PUMP LASERS IN EDFA**

(30) Priority: 27.07.2018 CN 201810840108
(71) Applicant: Accelink Technologies Co., Ltd., Wuhan, Hubei 430205 (CN)
(72) Inventor: YU, Zhenyu, Wuhan, Hubei 430205 (CN); BU, Qinlian, Wuhan, Hubei 430205 (CN); FU, Chengpeng, Wuhan, Hubei 430205 (CN)
(74) Representative: Frenkel, Matthias Alexander
(86) International application number: PCT/CN2018/123439
(87) International publication number: WO 2020/019661

(57) **Abstract**

An opposing pump structure for twin 980-nm pump lasers (2-1, 2-2) in an EDFA, the structure comprising an erbium-doped optical fiber (1), two 980-nm pump lasers (2-1, 2-2), two signal/pump combiners (3-1, 3-2), and anti-interference structures. The two 980-nm pump lasers (2-1, 2-2) output first pump light and second pump light, respectively, and the first pump light and the second pump light are injected into the erbium-doped optical fiber (1) in a forward direction and a reverse direction, respectively. An optical transmission path of the first pump light and an optical transmission path of the second pump light are separately provided with the anti-interference structures. The anti-interference structures are two fiber Bragg gratings (4-1, 4-2) or two optical filters (5-1, 5-2). The invention improves the optical paths of the opposing pump structure for twin 980-nm pump lasers (2-1, 2-2), and adds the fiber Bragg gratings or the optical filters to serve as anti-interference structures, so as to prevent residual pump light from either direction from entering the opposite direction, thereby eliminating mutual interference between the two opposing 980-nm pumps, and avoiding damage to tube cores.

## Description

### TECHNICAL FIELD

The present disclosure relates to the fields of optical communication technology, and in particular relates to an opposing pump structure for twin 980-nm pump lasers in EDFA.

### BACKGROUND

In an optical fiber communication system, an Erbium Doped Fiber Amplifier (EDFA) is an important relay device that extends the transmission distance of optical signals. Unlike optical-electric-optical relay amplification, the EDFA is a kind of light-to-light repeater. Since its first appearance in the late 1980s, the EDFA has been playing a pivotal role in the global optical communication system, and has been booming and widely used. A pump laser is an energy source for the EDFA to amplify the signal light. Pump light is injected into an erbium-doped fiber to excite erbium ions from a ground state to an upper energy level, and then to a metastable state without radiation. When signal light is injected into the doped fiber, in a case of erbium ions falling from the metastable state to the basic level, energy could be released and amplified light having the same direction, frequency, and phase as the incident signal light could be generated, that is, an optical amplification process is completed.

At present, there are mainly two types of pump lasers: 980-nm pump laser and 1480-nm pump laser. The 980-nm pump laser may have relatively strong noise suppression capability, while the 1480-nm pump laser may have relatively high energy conversion efficiency. Both the 980 and 1480-nm pump lasers are F-P lasers. The F-P laser is a multi-longitudinal mode laser with a broad spectrum, for example, a 20dB spectral width of the 1480-nm pump laser can reach 10nm or even 20nm. Emission and absorption spectra of Erbium ion is relatively steep in a 980-nm band, but relatively flat in a 1480-nm band. Correspondingly, an Erbium Doped Fiber (EDF) put higher requirements on the spectrum of the 980-nm pump laser. Therefore, it is necessary to write a fiber Bragg grating (FBG) on a pigtail of the 980-nm pump laser as an external cavity to further process the spectrum, so it is difficult to integrate an isolator on the package of the 980-nm pump laser; on the contrary, there is no need to add the FBG to a pigtail of the 1480-nm pump laser as an external cavity for further processing the spectrum, thus the 1480-nm pump laser may output in only the original spectrum. Correspondingly, since there is no FBG external cavity on the pigtail of the 1480-nm pump laser, an isolator can be integrated on a tail tube of the 1480-nm pump laser.

In terms of the optical path structure, a forward pump has a strong ability to suppress noise, and a backward pump has a high amplification gain. In an engineering design and application, it is often necessary to combine the forward pump and the backward pump together, so that the advantages of the forward pump and the backward pump can be combined to increase an output optical power while suppressing the noise. In an opposing pump structure, however, if residual pump light with the same or similar wavelength is injected into an opposing pump, it may cause lasing in the opposing pump and cause the failure of the opposing pump laser. That is, there is a risk of mutual interference between the two opposing pumps. In the above-mentioned 980-nm pump laser, the FBG on the pigtail of 980-nm pump laser belongs to an external cavity which is used in a filtering mode, and only the optical power of the desired wavelength is emitted; while there is no blocking effect for external stray pump light with other wavelengths and the external stray pump light can still be injected into the cavity of the pump laser. If the wavelength of the stray pump light is close to the wavelength of output light of the interfered pump laser, then there is a certain probability that the pump laser is subject to lasing, whereby destroying an original resonance mode of the pump laser cavity, and further causing the failure of the disturbed pump laser.

Since the output position of the 1480-nm pump laser is generally integrated with an isolator, two 1480-nm pump lasers can be used as opposing pump lasers. Given that the central wavelengths of the 980-nm pump laser and the 1480-nm pump laser are far apart from each other, the 980-nm pump laser and the 1480-nm pump laser can be used as opposing pump lasers. Since the 980-nm pump laser cannot be integrated with an isolator, the opposing pump structure for twin 980-nm pump lasers cannot be used directly. Therefore, there are only opposing pump structure for twin 980-nm pump 980 + 1480-nm pump and 1480-nm pump + 1480-nm pump in the current engineering design. In some engineering applications, a unidirectional 980-nm pump laser, a unidirectional 1480-nm pump laser, an opposing pump structure for 1480+1480-nm pump lasers or an opposing pump structure for 980+1480-nm pump lasers cannot meet the requirements, and only a 980+980 opposing pump structure is qualified. For example, the 980+980 opposing pump structure can well meet a good noise performance requirement for the opposing pump architecture. In another example, for some symmetrical array optical path EDFA, the 980+1480 opposing pump structure is not applicable for it cannot be symmetrical, and the 1480+1480 opposing pump structure is not applicable for it cannot achieve array symmetry due to its slow absorption. Only the 980+980 opposing pump structure is suitable for this case. In this situation, it is necessary to properly modify the optical path to prevent the two opposing 980-nm pump lasers from interfering each other.

In view of this, the above-mentioned defect in the prior arts is an urgent problem to be solved in this technical field.

### SUMMARY

The technical problem to be solved by the present disclosure is:
There is a risk of mutual interference between two 980-nm opposing pump lasers, since there currently is no 980-nm pump laser integrated with optical isolator on the market, and in the 980+980 opposing pump structure, if residual pump light with the same or similar wavelength is injected into the opposing pump lasers, it may cause lasing in the pump lasers and cause the opposing pump lasers to be failed.

The present disclosure provides following technical solutions to achieve the above objective.

The present disclosure provides an opposing pump structure for twin 980-nm pump lasers in EDFA, comprising an erbium-doped fiber 1, a first 980-nm pump laser 2-1, a second 980-nm pump laser 2-2, a signal/pump combiner 3-1, a second signal/pump combiner 3-2, and anti-interference structures;
the first 980-nm pump laser 2-1 being used to output first pump light and being connected to the first signal/pump combiner 3-1, and the first signal/pump combiner 3-1 being connected to a signal input end of the erbium-doped fiber 1, so that the first pump light is injected into the erbium-doped fiber 1 in a forward direction; the second 980-nm pump laser 2-2 being used to output second pump light and being connected to the second signal/pump combiner 3-2, and the second signal/pump combiner 3-2 being connected to a signal output end of the erbium-doped fiber 1 so that the second pump light is injected into the erbium-doped fiber 1 in a reverse direction;
wherein anti-interference structures are respectively arranged on a forward optical transmission path of the first pump light and a reverse optical transmission path of the second pump light to respectively resist interference of the first pump light to the second 980-nm pump laser 2-2 and interference of the second pump light on the first 980-nm pump laser 2-1.

Preferably, the anti-interference structure includes a first fiber Bragg grating 4-1 and a second fiber Bragg grating 4-2, the first fiber Bragg grating 4-1 being arranged on the transmission light path of the first pump light, and being used to pass through the first pump light and highly reflect the second pump light; and the second fiber Bragg grating 4-2 being arranged on the transmission light path of the second pump light, and being used to pass through the second pump light and highly reflect the first pump light.

Preferably, a central wavelength and bandwidth of a high reflection band of the first fiber Bragg grating 4-1 match the second pump light, and a central wavelength and bandwidth of a high reflection band of the second fiber Bragg grating 4-2 match the first pump light.

Preferably, the first fiber Bragg grating 4-1 is arranged between the first 980-nm pump laser 2-1 and the first signal/pump combiner 3-1, or between the first signal/pump combiner 3-1 and the signal input end of the erbium-doped fiber 1; and the second fiber Bragg grating 4-2 is arranged between the second 980-nm pump laser 2-2 and the second signal/pump combiner 3-2, or between the second signal/pump combiner 3-2 and the signal output end of the erbium-doped fiber 1.

Preferably, the first fiber Bragg grating 4-1 is written on a pigtail of the first 980-nm pump laser 2-1, or a pigtail of the first signal/pump combiner 3-1, or the signal input end of the erbium-doped fiber 1; and the second fiber Bragg grating 4-2 is written on a pigtail of the second 980-nm pump laser 2-2, or a pigtail of the second signal/pump combiner 3-2, or the signal output end of the erbium-doped fiber 1.

Preferably, the anti-interference structure includes a first optical filter 5-1 and a second optical filter 5-2, the first optical filter 5-1 being arranged between the first 980-nm pump laser 2-1 and the first signal/pump combiner 3-1, and the second optical filter 5-2 being arranged between the second 980-nm pump laser 2-2 and the second signal / pump combiner 3-2.

Preferably, the first optical filter 5-1 and the second optical filter 5-2 both may be a narrow-band band-pass filter; wherein the first optical filter 5-1 allows the first pump light to pass through and shields the second pump light, and the second optical filter 5-2 allows the second pump light to pass through and shields the first pump light.

Preferably, the central wavelengths of the first pump light and the second pump light are both selected in a range of 973-981.5 nm.

Preferably, the first pump light and the second pump light are different with each other in central wavelength, and a central wavelength difference thereof is 4-7 nm.

Preferably, the erbium-doped optical fiber 1 is only a single section, or one cascaded from at least two sections.

The beneficial effects of the present invention are as follows.

In opposing pump structure for twin 980-nm pump lasers in EDFA provided by the present disclosure, an optical path of the 980+980 opposing pump structure is appropriately improved, and fiber Bragg gratings or optical filters are added as anti-interference structures, such that residual pump light in any direction cannot be injected into the opposing pump, thereby avoiding the mutual interference between the two 980 opposing pumps, and avoiding the failure of the pump laser. Moreover, compared with an integrated optical isolator, the solution adopting fiber Bragg grating and optical filter is of low loss, small size and low cost..

### BRIEF DESCRIPTION OF THE DRAWINGS

For a clear illustration of technical solutions of embodiments of the present disclosure, the drawings necessary for the embodiments of the present disclosure will be briefly introduced hereinafter. Obviously, the drawings described below are only some embodiments of the present disclosure. For those of ordinary skilled in the art, other drawings can be obtained based on these drawings without creative work.
FIG. 1 is an opposing pump structure for twin 980-nm pump lasers without an anti-interference structure;
FIG. 2 is an opposing pump structure for twin 980-nm pump lasers provided with an optical isolator;
FIG. 3 is an opposing pump structure for twin 980-nm pump lasers in an EDFA provided by an embodiment of the present disclosure (fiber Bragg gratings are added on the pumping path);
FIG. 4 is an opposing pump structure for twin 980-nm pump lasers in an EDFA provided by an embodiment of the present disclosure (fiber Bragg gratings are added on the main optical path);
FIG. 5 is another opposing pump structure for twin 980-nm pump lasers in an EDFA provided by an embodiment of the present disclosure (optical filters are added on the pumping path).

### DETAILED DESCRIPTION

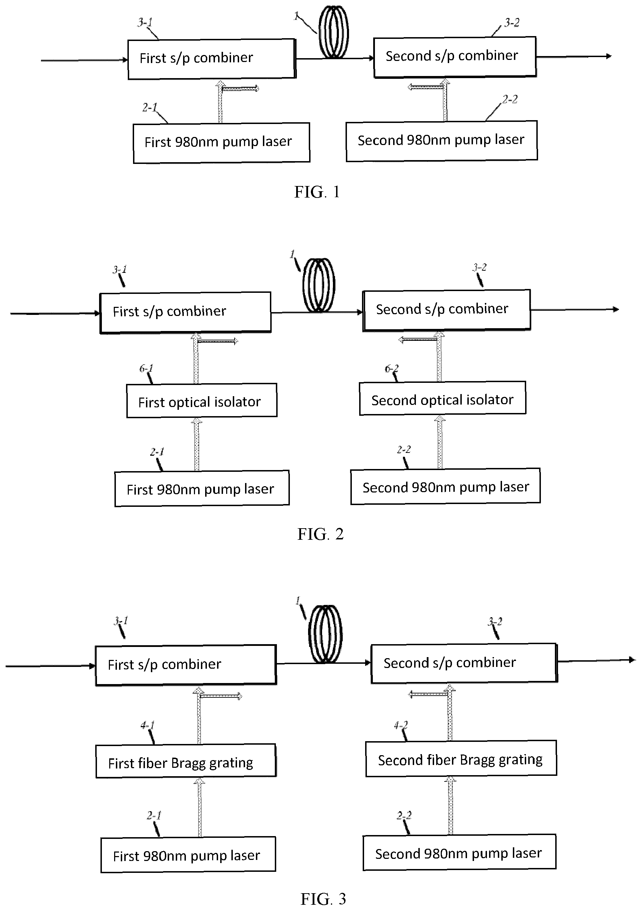

Without considering the mutual interference between two 980-nm opposing pumps, an original twin 980-nm pump structure comprises, as shown in FIG. 1, an erbium-doped fiber 1, a first 980-nm pump laser 2- 1, a second 980-nm pump laser 2-2, a first signal/pump combiner 3-1, and a second signal/pump combiner 3-2. The first 980-nm pump laser 2-1 is used to output first pump light. An output end of the first 980-nm pump laser 2-1 is connected to a pump end of the first signal/pump combiner 3-1, and a signal output end of the first signal/pump combiner 3-1 is connected to a signal input end of the erbium-doped optical fiber 1, so that the first pump light is injected into the erbium-doped fiber optical fiber 1 in a forward direction, thus the first 980-nm pump laser 2-1, the first signal/pump combiner 3-1, and the erbium-doped fiber 1 constitute a forward optical transmission path of the first pump light. The second 980-nm pump laser 2-2 is used to output second pump light. An output end of the second 980-nm pump laser 2-2 is connected to a pump end of the second signal/pump combiner 3-2, and a signal input end of the second signal/pump combiner 3-2 is connected to a signal output end of the erbium-doped fiber 1, so that the second pump light is injected into the Erbium-doped fiber 1 in a reverse direction, thus the second 980-nm pump laser 2-2, the second signal/pump combiner 3-2 and the erbium-doped fiber 1 constitute an opposite optical transmission path of the second pump light.

Referring to FIG. 1, signal light enters from an input port, and it sequentially passes through the first signal/pump combiner 3-1, the erbium-doped fiber 1, and the second signal/pump combiner 3-2, finally it reaches an output port. Here, a transmission direction of the signal light is taken as the forward direction, and a transmission path of the signal light is taken as a main optical path. The first pump light and the signal light are injected into the erbium-doped fiber 1 in the same direction, and the second pump light is injected into the erbium-doped fiber 1 in an opposite direction. The forward optical path specifically is: the first pump light is output by the first 980-nm pump laser 2-1, then it is coupled with the signal light in the first signal/pump combiner 3-1, and finally it is injected into the erbium-doped fiber 1 in the forward direction. The reverse optical path specifically is: the second pump light is output by the second 980-nm pump laser 2-2, then it is coupled with the signal light in the second signal/pump combiner 3-2, and finally it is injected into the erbium-doped fiber 1 in the reverse direction. The first 980-nm pump laser 2-1 and the first signal/pump combiner 3-1 constitute a first pump optical path, and the second 980-nm pump laser 2-2 and the second signal/pump combiner 3-2 constitute a second pump optical path.

In the theoretical opposing pump structure shown in FIG. 1, there is a risk of mutual interference between two 980 opposing pumps, and the optical paths need to be appropriately improved to eliminate the mutual interference between two 980 opposing pumps. If an optical isolator is integrated on the 980-nm pump laser, that is, before the 980-nm pump laser is connected to the corresponding signal/pump combiner, it is firstly connected to the optical isolator, theoretically the mutual interference between two 980-nm pump lasers can be eliminated by means of an unidirectional transmission of optical isolator. Referring to FIG. 2, a first optical isolator 6-1 is provided between the first 980-nm pump laser 2-1 and the first signal/pump combiner 3-1 for allowing the first pump light to pass through in only one direction; and a second optical isolator 6-2 is provided between the second 980-nm pump laser 2-2 and the second signal/pump combiner 3-2 for allowing the second pump light to pass through in only one direction. Therefore, when the second pump light reaches the first optical isolator 6-1 in the reverse direction, it cannot reach the first 980-nm pump laser 2-1 through the first optical isolator 6-1. In the same way, the first pump light cannot reach the second 980-nm pump laser 2-2 through the second optical isolator 6-2. However, the optical isolator has a large volume, a large loss, and a high cost, and it is not easy to be integrated on a 980-nm pump laser.

In order to make the objectives, technical solutions and advantages of the present disclosure clearer, the present disclosure is further described in detail below in conjunction with the accompanying drawings and embodiments. It should be understood that the specific embodiments described herein are only used to explain the present disclosure, but not to limit the present disclosure.

In addition, the technical features involved in various embodiments of the present disclosure described below can be combined with each other as long as they do not conflict with each other. The present disclosure is described in detail below with reference to the accompanying drawings and embodiments.

### Embodiment 1

In an embodiment of the present disclosure, there is provided an opposing pump structure for twin 980-nm pump lasers in EDFA, comprising an erbium-doped fiber 1, a first 980-nm pump laser 2-1, a second 980-nm pump laser 2-2, a first signal/pump combiner 3-1, a second signal/pump combiner 3-2, and an anti-interference structure. On the basis of FIG. 1, anti-interference structures are respectively provided on the forward optical transmission path of the first pump light and the reverse optical transmission path of the second pump light to respectively resist interference of the first pump light on the second 980-nm pump laser 2-2 and interference of the second pump light on the first 980-nm pump laser 2-1.

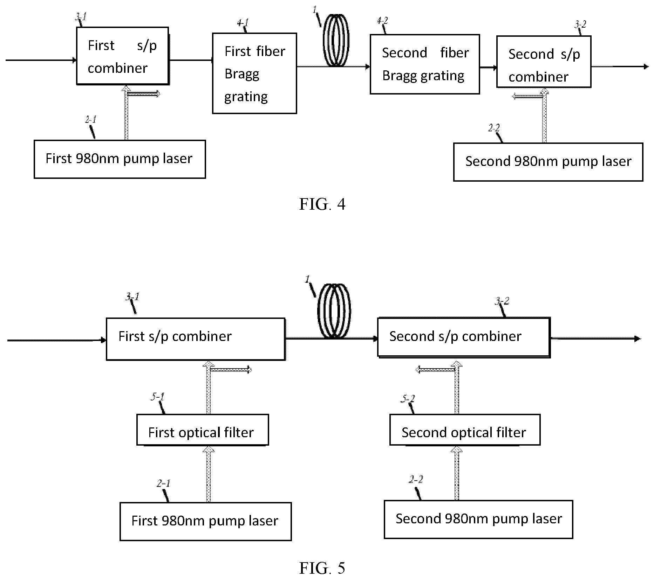

As shown in FIGS. 3 and 4, in the embodiments of the present disclosure, the anti-interference structure comprises a first fiber Bragg grating 4-1 and a second fiber Bragg grating 4-2, wherein the first fiber Bragg grating 4-1 is arranged on the optical transmission path of the first pump light and is used to allow the first pump light to pass through and highly reflect the second pump light, and the second fiber Bragg grating 4-2 is arranged on the optical transmission path of the second pump light and is used to allow the second pump light to pass through and highly reflect the first pump light.

In an opposing pump structure for twin 980-nm pump lasers used in EDFA provided in the present disclosure, optical paths of the 980+980 opposing pump structure are appropriately improved, and a fiber Bragg grating is respectively added to the optical transmission paths of two pump lights and each can highly reflect residual pump light in another direction, so that the residual pump light in another direction cannot be injected into the opposing pump, whereby avoiding the mutual interference between two 980-nm opposing pumps with each other and avoiding the failure of the opposing pump laser. Moreover, compared with the integrated optical isolator, the solution adopting optical fiber Bragg gratings has the advantages of small loss, small size and low cost.

Referring specifically to FIG. 3, the first fiber Bragg grating 4-1 is arranged on a first pump light path, and the second fiber Bragg grating 4-2 is arranged on a second pump light path. Specifically, the first fiber Bragg grating 4-1 is arranged between the first 980-nm pump laser 2-1 and the first signal/pump combiner 3-1, and the second fiber Bragg grating 4-2 is arranged between the second 980-nm pump laser 2-2 and the second signal/pump combiner 3-2. Welding can be applied to connections between the first 980-nm pump laser 2-1 and the first fiber Bragg grating 4-1, between the first fiber Bragg grating 4-1 and the first signal/pump combiner 3-1, between the second 980-nm pump laser 2-2 and the second fiber Bragg grating 4-2, and between the second fiber Bragg grating 4-2 and the second signal/pump combiner 3-2. Alternatively, the first fiber Bragg grating 4-1 may be welded onto a pigtail of the first 980-nm pump laser 2-1, and the second fiber Bragg grating 4-2 may be welded onto a pigtail of the second 980-nm pump laser 2-2.

In order to eliminate the mutual interference between the first 980-nm pump laser 2-1 and the second 980-nm pump laser 2-2, in the embodiments of the present disclosure, the first fiber Bragg grating 4-1 and the second fiber Bragg grating 4-2 may both be a high-reflectivity fiber Bragg grating, whose 30dB bandwidth of the high reflection windows is 4-7nm and reflectivity is above 99%. A central wavelength and bandwidth of a high reflection band of the first fiber Bragg grating 4-1 match a central wavelength and bandwidth of the second pump light so as to highly reflect the second pump light, and a central wavelength and bandwidth of the high reflection band of the second fiber Bragg grating 4-2 match a central wavelength and bandwidth of the first pump light so as to highly reflect the first pump light. Therefore, when the first pump light is transmitted in the forward direction, it can pass through the first fiber Bragg grating 4-1 with low loss and then continue to be transmitted, and after the second pump light passes through the second signal/pump combiner 3-2, the erbium-doped fiber 1, and the first signal/pump combiner 3-1, remaining second pump light reaches the first fiber Bragg grating 4-1 in the reverse direction, and can be reflected to the greatest extent, such that it is difficult for the second pump light to pass through the first fiber Bragg grating 4-1 to reach the first 980-nm pump laser 2-1, whereby eliminating the interference of the second 980-nm pump laser 2-2 to the first 980-nm pump laser 2-1. Similarly, when the second pump light is transmitted in the reverse direction, it can pass through the second fiber Bragg grating 4-2 with low loss and then continue to transmit, and when the first pump light is forward transmitted to the second fiber Bragg grating 4-2, it can be reflected to the greatest extent, such that it is difficult for the first pump light to pass through the second fiber Bragg grating 4-2 to reach the second 980-nm pump laser 2-2, whereby eliminating the interference of the first 980-nm pump laser 2-1 to the second 980-nm pump laser 2-2.

In the embodiments of the present disclosure, the central wavelengths of the first pump light and the second pump light both can be selected in a range of 973-981.5 nm. It should be noted that in the embodiments of the present disclosure, in order to prevent the first pump light from passing through the second fiber Bragg grating 4-2, or the second pump light from passing through the first fiber Bragg grating 4-1, the first pump light and the second pump light have different central wavelengths, and the central wavelength difference thereof is in a range of 4-7 nm. If the central wavelength difference is too small, it is difficult to separate the two pump lights; and when the central wavelength difference is greater than 4nm, the two pump lights can be distinguished from each other without any difficulty. In the opposing pump structure for twin 980-nm pump lasers of this embodiment, the first 980-nm pump laser 2-1 and the second 980-nm pump laser 2-2 are select wavelengths in a mismatched manner, for example, 973 and 977 nm are selected respectively. The bandwidth of high reflection window of FBG can actually be determined by the difference in the central wavelength of the two opposing pump lasers. Assuming that the central wavelength difference of the two pumps is 4nm, the bandwidth of the high reflection window can be set to 4nm; if the central wavelength difference of the two pumps is 7nm, the bandwidth of the high reflection window can be set to 4 ∼ 7nm.

Referring to FIG. 4, in an embodiment of the present disclosure, the first fiber Bragg grating 4-1 and the second fiber Bragg grating 4-2 may also be arranged on the main optical path of the signal light respectively, specifically, the first fiber Bragg grating 4-1 is arranged between the first signal/pump combiner 3-1 and the signal input end of the erbium-doped fiber 1, and the second fiber Bragg grating 4-2 is arranged between the second signal/pump combiner 3-2 and the signal output end of the erbium-doped fiber 1. In this arrangement, the first fiber Bragg grating 4-1 can be passed through by the signal light and the first pump light, and highly reflect the second pump light, and the second fiber Bragg grating 4-2 can be passed through by the signal light and the second pump light, and highly reflect the first pump light. In this way, the two fiber Bragg gratings are transferred from the pump light path to the main light path of the signal light, but they still can eliminate the mutual interference between the two 980-nm pump lasers. The specific principle is similar to the above introduction and will not be repeated here. Welding can be applied to connections between the first fiber Bragg grating 4-1 and the first signal/pump combiner 3-1, between the first fiber Bragg grating 4-1 and the erbium-doped fiber 1, between the second fiber Bragg grating 4-2 and the second signal/pump combiner 3-2, and between the second fiber Bragg grating 4-2 and the erbium-doped fiber 1.

On the basis of the embodiments of the present disclosure, the first fiber Bragg grating 4-1 can also be arranged on the first pump light path, and the second fiber Bragg grating 4-2 can also be arranged on the main optical path of the signal light path. Specifically, the first fiber Bragg grating 4-1 is arranged between the first 980-nm pump laser 2-1 and the first signal/pump combiner 3-1, and the second fiber Bragg grating 4-2 is arranged between the second signal/pump combiner 3-2 and the signal output end of the erbium-doped fiber 1. Alternatively, the first fiber Bragg grating 4-1 may be arranged on the main optical path of the signal light, and the second fiber Bragg grating 4-2 may be arranged on the second pumping optical path. Specifically, the first fiber Bragg grating 4-1 is arranged between the first signal/pump combiner 3-1 and the signal input end of the erbium-doped fiber 1, and the second fiber Bragg grating 4-2 is arranged between the second signal/pump combiner 3-2 and the signal output end of the erbium-doped optical fiber 1; in addition, the specific connection mode and working principle are not repeated here.

In comparison, when the first fiber Bragg grating 4-1 is arranged on the first pump light path, and the second fiber Bragg grating 4-2 is arranged on the second pump light path, the first fiber Bragg grating 4-1 and the second fiber Bragg grating 4-2 could not cause additional insertion loss to the signal light, so this arrangement is better.

In embodiments of the present invention, the first fiber Bragg grating 4-1 and the second fiber Bragg grating 4-2 can also be directly written on the pigtail of the device. Specifically, the first fiber Bragg grating 4-1 can be directly written on the pigtail of the first 980-nm pump laser 2-1, or on the pigtail of the first signal/pump combiner 3-1, or on the signal input end of the erbium-doped optical fiber 1, and the second fiber Bragg grating 4-2 can be directly written on the pigtail of the second 980-nm pump laser 2-2, or on the pigtail of the second signal/pump combiner 3-2, or on the signal output end of the erbium-doped fiber 1. Through this arrangement, in the entire optical path transmission, the first fiber Bragg grating 4-1 can still highly reflect the second pump light, and the second fiber Bragg grating 4-2 can still highly reflect the first pump light, whereby still being able to eliminate the mutual interference between the two 980-nm pump lasers.

With reference to FIGS. 3 and 4, in the embodiment of the present invention, the erbium-doped optical fiber 1 is only a single section, or one cascaded from at least two sections. Since the amplifier made of a single-section erbium-doped fiber has a serious noise figure degradation when its output power is close to its saturated output power, therefore, in order to achieve a larger gain and a lower noise figure, the erbium-doped fiber can be divided into two sections, i.e. a front section and a rear section, and the front erbium-doped fiber is shorter than the rear erbium-doped fiber, and the two erbium-doped fibers are separated by an isolator, such that the propagating noise in reverse direction in the rear section of the erbium-doped fiber can be effectively isolated and prevented from entering the front section of the erbium-doped fiber. In this way, the reverse noise will not be amplified in the front section of the erbium-doped fiber, and the noise figure of the first stage can be reduced. In a multi-stage system, the total noise figure is mainly affected by the noise figure of the first stage. The noise performance of the entire amplifier can be optimized. In the same way, the erbium-doped fiber can be divided into three or more sections, which will not be repeated here.

### Embodiment 2

On the basis of the above embodiment 1, an embodiment of the present disclosure also provides another opposing pump structure for twin 980-nm pump lasers used in EDFA, as shown in FIG. 5, which is different from embodiment 1 in that: the anti-interference structures are changed from the two fiber Bragg gratings in embodiment 1 to two optical filter structures, that is to say, before the 980-nm pump lasers are respectively connected to the corresponding signal/pump combiners, an respective optical filter is arrange between the 980-nm pump laser and the signal/pump combiner and is used to eliminate the mutual interference between two 980-nm pump lasers by means of its function of selecting a wave with a specific wavelength.

Referring to FIG. 5, the opposing pump structure for twin 980-nm pump lasers provided by this embodiment comprises an erbium-doped fiber 1, a first 980-nm pump laser 2-1, a second 980-nm pump laser 2-2, a first signal/ pump combiner 3-1, a second signal/pump combiner 3-2, and an anti-interference structure. The anti-interference structure includes a first optical filter 5-1 and a second optical filter 5-2. The first optical filter 5-1 is arranged on a first pump light path, and the second optical filter 5-2 is arranged on a second pump light path. Specifically, the first optical filter 5-1 is arranged between an output end of the first 980-nm pump laser 2-1 and a pump end of the first signal/pump combiner 3-1, and the second optical filter 5- 2 is arranged between an output end of the second 980-nm pump laser 2-2 and a pump end of the second signal/pump combiner 3-2. The specific connection of each device may refer to Embodiment 1, and it will not be repeated here. Welding can be applied to connections between the first 980-nm pump laser 2-1 and the first optical filter 5-1, between the first optical filter 5-1 and the first signal/pump combiner 3-1, between the second 980-nm pump laser 2-2 and the second optical filter 5-2, and between the second optical filter 5-2 and the second signal/pump combiner 3-2.

In the embodiment of the present disclosure, the first optical filter 5-1 and the second optical filter 5-2 are both narrow-band band-pass filters, which may allow optical signals with specific wavelengths to pass through while shielding optical signals with other wavelengths. The bandwidth of their narrowband window 30dB is 3-7nm, and the transmission insertion loss of the filters is within 0.6dB. The first optical filter 5-1 can only allow light with a first pump light wavelength to pass through and shield light with other wavelengths, and the second optical filter 5-2 can only allow light with a second pump wavelength to pass through and shield light with other wavelengths. Therefore, when the second pump light passes through the second signal/pump combiner 3-2, the erbium-doped fiber 1 and the first signal/pump combiner 3-1, and residual second pump light reaches the first optical filter 5-1 in the reverse direction, since the first optical filter 5-1 has a shielding effect on the second pump light, the second pump light cannot pass through the first optical filter 5-1 and reach the first 980-nm pump laser 2-1, thereby eliminating the interference of the second 980-nm pump laser 2-2 on the first 980-nm pump laser 2-1. Similarly, when the first pump light is transmitted to the second optical filter 5-2, since the second optical filter 5-2 can only allow the second pump light to pass through but shield the first pump light, the first pump light cannot pass through the second optical filter 5-2 and reach the second 980-nm pump laser 2-2, thereby eliminating the interferes of the first 980-nm pump laser 2-1 on the second 980-nm pump laser 2-2.

In the embodiment of the present disclosure, the central wavelengths of the first pump light and the second pump light can be selected in a range of 973-981.5 nm. It should be noted that, in the embodiment of the present disclosure, in order to prevent the first pump light from passing through the second optical filter 5-2 and prevent the second pump light from passing through the first optical filter 5- 1, the first pump light and the second pump light have different central wavelengths, and the central wavelength difference thereof is in a range of 4-7 nm. If the central wavelength difference is too small, the two pump light is difficult to be separated; and when the central wavelength difference is greater than 4nm, the two pump light may be distinguished without any difficulty. In the opposing pump structure for twin 980-nm pump lasers of this embodiment, the first 980-nm pump laser 2-1 and the second 980-nm pump laser 2-2 are misaligned to select wavelengths, for example, 973 and 977 nm.

In the opposing pump structure for twin 980-nm pump lasers used in EDFA provided by the present disclosure, the optical path of the 980+980 opposing pump structure is appropriately improved, and an optical filter is added to the optical transmission path of the two pump lights respectively, wherein each optical filter only allows the corresponding pump light to pass through, and does not allow the residual pump light in another direction to pass through, so that the residual pump light in another direction cannot be injected into the opposing pump, thereby avoiding the mutual interference between the two 980 opposing pumps and the failure of the opposing pump lasers. Moreover, compared with the integrated optical isolator, the optical filter has the advantages of small loss, small size and low cost.

The above descriptions are only preferred embodiments of the present invention, and are not intended to limit the present invention. Any modification, equivalent replacement and improvement made within the spirit and principle of the present invention shall be included in the scope of protection of the invention of the present invention.

## Claims

1. An opposing pump structure for twin 980-nm pump lasers in an EDFA, **characterized in** comprising an erbium-doped fiber (1), a first 980-nm pump laser (2-1), a second 980-nm pump laser (2-2), a first signal/pump combiner (3-1), a second signal/pump combiner (3-2), and anti-interference structures;
the first 980-nm pump laser (2-1) being used to output first pump light and being connected with the first signal/pump combiner (3-1), and the first signal/pump combiner (3-1) being connected to a signal input end of the erbium-doped fiber (1), so that the first pump light is injected into the erbium-doped fiber (1) in a forward direction; the second 980-nm pump laser (2-2) being used to output second pump light and being connected with the second signal/pump combiner (3-2), and the second signal/pump combiner (3-2) being connected to a signal output end of the erbium-doped fiber (1), so that the second pump light is injected into the erbium-doped optical fiber (1) in a reverse direction;
wherein anti-interference structures are respectively provided on a forward optical transmission path of the first pump light and a reverse optical transmission path of the second pump light to respectively resist interference of the first pump light on the second 980-nm pump laser (2-2), and interference of the second pump light on the first 980-nm pump laser (2-1).

2. The opposing pump structure for twin 980-nm pump lasers in an EDFA of claim 1, wherein the anti-interference structure includes a first fiber Bragg grating (4-1) and a second fiber Bragg grating (4-2), the first fiber Bragg grating (4-1) being arranged on the optical transmission path of the first pump light for passing through the first pump light and highly reflecting the second pump light, and the second fiber Bragg grating (4-2) being arranged on the optical transmission path of the second pump light for passing through the second pump light and highly reflecting the first pump light.

3. The opposing pump structure for twin 980-nm pump lasers in an EDFA of claim 2, wherein a central wavelength and bandwidth of a high reflection band of the first fiber Bragg grating (4-1) match the second pump light, and a central wavelength and bandwidth of a high reflection band of the second fiber Bragg grating (4-2) match the first pump light.

4. The opposing pump structure for twin 980-nm pump lasers in EDFA of claim 2, wherein the first fiber Bragg grating (4-1) is arranged between the first 980-nm pump laser (2-1) and the first signal/pump combiner (3-1), or between the first signal/pump combiner (3-1) and a signal input ends of the erbium-doped fiber (1); and the second fiber Bragg grating (4-2) is arranged between the second 980-nm pump laser (2-2) and the second signal/pump combiner (3-2), or between the second signal/pump combiner (3-2) and a signal output end of the erbium-doped fiber (1).

5. The opposing pump structure for twin 980-nm pump lasers in EDFA of claim 2, wherein the first fiber Bragg grating (4-1) is written on a pigtail of the first 980-nm pump laser (2-1), or a pigtail of the first signal/pump combiner (3-1), or the signal input end of the erbium-doped fiber (1); and the second fiber Bragg grating (4-2) is written on a pigtail of the second 980-nm pump laser (2-2), or a pigtail of the second signal/pump combiner (3-2), or the signal output end of the erbium-doped optical fiber (1).

6. The opposing pump structure for twin 980-nm pump lasers in EDFA of claim 1, wherein the anti-interference structure includes a first optical filter (5-1) and a second optical filter (5-2), the first optical filter (5-1) being arranged between the first 980-nm pump laser (2-1) and the first signal/pump combiner (3-1), and the second optical filter (5-2) is arranged between the second 980-nm pump laser (2-2) and the second signal/pump combiner (3-2).

7. The opposing pump structure for twin 980-nm pump lasers in EDFA of claim 6, wherein the first optical filter (5-1) and the second optical filter (5- 2) both are narrow-band band-pass filters; wherein the first optical filter (5-1) allows the first pump light to pass through but shields the second pump light, and the second optical filter (5 -2) allows the second pump light to pass through but shields the first pump light.

8. The opposing pump structure for twin 980-nm pump lasers in EDFA of any one of claims 2-7, wherein central wavelengths of the first pump light and the second pump light both are selected from the range of 973-981.5nm.

9. The opposing pump structure for twin 980-nm pump lasers in EDFA of claim 8, wherein the first pump light is different with the second pump light in the central wavelength, and the central wavelength difference thereof is 4-7nm.

10. The opposing pump structure for twin 980-nm pump lasers in EDFA of claim 1, wherein the erbium-doped fiber (1) is a single whole section or one cascaded from at least two sections.
